# EUROPÄISCHE PATENTSCHRIFT

(11) **EP 0 440 894 B1**
(45) Veröffentlichungstag und Bekanntmachung des Hinweises auf die Patenterteilung: **03.08.1994**
(21) Anmeldenummer: 90122128.3
(22) Anmeldetag: 20.11.1990
(51) Int. Cl.: G01D 1/18

(54) **Triggerschaltung mit selbsteinstellendem Referenzwert**
Trigger circuit with self-adjusting reference value
Circuit de déclenchement à réglage automatique de la valeur de référence

(30) Priorität: 30.12.1989 DE 3943394
(43) Veröffentlichungstag der Anmeldung: 14.08.1991
(73) Patentinhaber: ROBERT BOSCH GMBH, 70442 Stuttgart (DE)
(72) Erfinder: Locher, Johannes, Ing.grad., W-7000 Stuttgart 50 (DE); Fischer, Werner, Dipl.-Ing., W-7258 Heimsheim (DE); Schmidt, Wolfgang, Ing., W-7143 Vaihingen/Enz (DE)

(56) Entgegenhaltungen:
- DE-C- 2 614 947
- GB-A- 1 395 163
- US-A- 4 561 404
- PATENT ABSTRACTS OF JAPAN, vol. 13, no. 254 (E-772)(3602), 13. Juni 1989 & JP-A-1 51 715

## Beschreibung

### Stand der Technik

Die Erfindung betrifft eine Triggerschaltung, die Amplituden des Signalverlaufs eines periodischen Signals mit vom vorausgehenden Signalverlauf dieses Signals abhängigen Referenzwerten vergleicht und beim Erreichen des jeweiligen Referenzwerts ein Triggersignal abgibt, und mit einem Speicher für den jeweiligen Referenzwert.

Für den optimalen Betrieb einer Brennkraftmaschine mittels eines Steuergeräts ist es erforderlich, unter anderem den jeweiligen Spritzbeginn von Einspritzventilen des Motors zu erfassen. Hierzu wird eine Triggerschaltung eingesetzt, die das elektrische Signal eines mit dem jeweiligen Einspritzventil zusammenwirkenden Gebers auswertet. Es erfolgt eine Triggerung, das heißt, Auswertung der Amplituden des Signalverlaufs des periodischen, vom Geber stammenden Signals. Die durch Vergleich mit einem Referenzwert erfolgende Triggerung wird als Zeitpunkt des Spritzbeginns herangezogen. Dieser wird an einen Rechner des Steuergeräts weitergegeben, der den ermittelten Spritzbeginn mit einem vorbestimmten Kennfeldwert des Steuergeräts vergleicht, wobei eine Regelung über einen Spritzversteller derart erfolgt, daß der Einspritzzeitpunkt stets den optimalen, im Kennfeld niedergelegten Wert annimmt. Hierdurch läßt sich die Abgasqualität verbessern und ein ökonomischer Kraftstoffverbrauch erzielen. Eine Problematik besteht darin, daß die Größe und die Form des Signals in Abhängigkeit von vielen Motorparametern stark schwankt. So verändert sich die Amplitude des Signals mit der Drehzahl der Brennkraftmaschine. Dies gilt auch für die Signalform, insbesondere auch für die Signalflanken. Es wurde festgestellt, daß der Spritzbeginn aus dem Signal mit hinreichender Sicherheit ermittelbar ist, wenn man stets dann eine Triggerung vornimmt, wenn die Signalamplitude einer betrachteten Periode des Signals ca. 20% der maximalen Signalamplitude der vorhergehenden Signalperiode beträgt. Dies setzt also voraus, daß ein Referenzwert der vorhergehenden Signalperiode zur Verfügung steht, der ca. 20% der zugehörigen maximalen Signalamplitude beträgt. Erreicht das Signal in der betrachteten Periode diesen Referenzwert, so wird das Triggersignal abgegeben und dem Rechner des Steuergeräts zugeführt, der den Vergleich mit dem Kennlinienwert und die bereits erwähnte Regelung durchführt. Nachteilig ist, daß das Signal des Gebers unter Umständen Nachprellimpulse aufweist mit Amplitudenspitzen, die größer sind als die Amplitude des eigentlichen Nutzsignals und mit dem gesuchten Spritzbeginn nichts zu tun haben. Hierdurch wird das Ergebnis verfälscht.

Aus der DE-OS 26 14 947 ist eine Schaltungsanordnung zur Lage-Erkennung eines rotierenden Teils bekannt. Es ist ein induktiver Geber vorgesehen, der bei jedem Umlauf des Teils eine entsprechende Wechselspannung abgibt, die gleichgerichtet und auf einen Integrierkondensator gegeben wird. Der Integrierkondensator ist an den einen Eingang eines Komparators angeschlossen. Die Wechselspannung wird ferner über einen Vorwiderstand an eine Zenerdiode angelegt, die an einen weiteren Eingang des Komparators angeschlossen ist. Die genannte Integration führt dazu, daß bei einfallenden Störimpulsen diese ebenfalls im Verhältnis ihrer Spannungszeitfläche zu einer Erhöhung der Schwellenspannung des Komparators beitragen und dadurch berücksichtigt werden.

Aus der GB-A-1 395 163 ist ein Schaltkreis bekannt, der auf einen Spannungspegel anspricht, und insbesondere bei Triggersystemen für die Zeitbasis eines Oszillographen verwendet wird. So wird der Triggerwert der Schaltungsanordnung, der durch einen Gleichspannungsreferenzpegel bestimmt ist, automatisch und kontinuierlich im wesentlichen mittig zwischen die Spitzenwerte des Eingangstriggersignals justiert.

Aus den Patent-Abstracts of Japan zur JP-A-15 17 15 ist ein automatischer Steuerkreis für einen Schwellwert bekannt. Die Höhe der Amplitude des Eingangssignals bestimmt den Schwellwert, um eine reproduzierte Schwingungsform zu erhalten, die nahe dem Originalsignal ist.

Aus der US-A-4 561 404 ist ein Brennstoffeinspritzsystem bekannt, bei dem Referenzwerteinstelleinrichtungen für eine vorbestimmte Anzahl von Ventilöffnungsgrad-Referenzwerten vorhanden sind.

Bei allen diesen Einrichtungen tragen einfallende Störimpulse ebenfalls im Verhältnis ihrer Spannungszeitfläche zu einer Erhöhung der Schwellenspannung des Komparators bei. Bei diesen Einrichtungen werden Nachprellimpulse bei der Bildung des Referenzwerts berücksichtigt und führen zu einer Verfälschung des Referenzwerts.

### Vorteile der Erfindung

Die erfindungsgemäße Triggerschaltung mit den im unabhängigen A anspruch 1 genannten Merkmalen hat demgegenüber den Vorteil, daß auftretende Störsignale, insbesondere Nachprellimpulse, ausgeblendet werden und dadurch für die Ermittlung des Referenzwerts unberücksichtigt bleiben. Hierdurch ist es möglich, sehr genau den Spritzbeginn (SB) zu ermitteln, so daß eine optimale Betriebsführung der Brennkraftmaschine möglich wird. Die Erfindung ist jedoch nicht auf die Anwendung in der Kraftfahrzeugelektronik beschränkt, sondern kann auch auf anderen Gebieten eingesetzt werden. Die erfindungsgemäße Ausblendung der Störimpulse erfolgt dadurch, daß der Referenzwert lediglich von einem Anteil einer Periode des Signals bestimmt ist. Es wird daher nur der die reine Nutzinformation aufweisende Anteil der jeweiligen Periode ausgewertet. Der andere Anteil bleibt unberücksichtigt.

Nach einer Weiterbildung der Erfindung ist vorgesehen, daß nur die erste Halbwelle jeder Periode des Signals für die Bestimmung des Referenzwerts herangezogen ist. Hierbei handelt es sich bevorzugt um die positive Halbwelle des Signals. Erfahrungsgemäß treten erst nach Durchlaufen einer negativen Halbwelle die erwähnten Prellimpulse auf. Im Bereich der negativen Halbwelle liegt der Zeitpunkt, in dem das zugehörige Einspritzventil seinen geöffneten Zustand erreicht. Die Nachprellimpulse liegen zeitlich im Bereich des Spritzendes.

Vorteilhaft ist es, wenn der Speicher als Kondensator ausgebildet ist. Die Kondensatorspannung bildet dann den Referenzwert. Um zum Beispiel den eingangs erwähnten 20%-Wert der Spitzenamplitude der vorhergehenden Signalperiode ermitteln zu können, wird ein Referenzwert verwendet, der proportional zu dem erwähnten Spitzenwert der ersten Halbwelle ist, das heißt, er beträgt -vorzugsweise durch Verwendung eines Spannungsteilers- 20% der maximalen Amplitude dieser Halbwelle.

Nach einem bevorzugten Ausführungsbeispiel ist ein erster Komparator vorgesehen, der bei dem ersten, innerhalb einer Periode erfolgenden Vorzeichenwechsel des Signals ein Ausgangssignal abgibt, daß eine durch das Signal erfolgende Aufladung des Kondensators stoppt. Der Vorzeichenwechsel, der der ersten, positiven Halbwelle folgt und somit zwischen dieser und der nachfolgenden negativen Halbwelle liegt, wird detektiert und zum Stoppen der Kondensatoraufladung herangezogen, so daß nachfolgende Signalanteile, insbesondere Störimpulse/Prellimpulse nicht berücksichtigt werden. Im Hinblick auf den Vorzeichenwechsel ist hier von einer fiktiven Nullinie auszugehen, die nicht auf dem Potential "Null-Volt" zu liegen braucht. Zum Beispiel ist es durchaus möglich, daß diese Nullinie den Pegel 4,9 Volt aufweist.

Nach einem speziellen Ausführungsbeispiel liegt eine Diode in Reihe zu dem Kondensator, wobei die Diode von dem ersten Komparator in ihren Sperrzustand steuerbar ist. Tritt der erwähnte Vorzeichenwechsel des Signals auf, so schaltet der erste Komparator und sperrt dadurch die Diode, so daß die Aufladung des Kondensators gestoppt wird.

Es ist vorteilhaft, wenn der erste Komparator eine monostabile Funktion aufweist, wobei die Rückschaltung in seinen Ausgangszustand erst erfolgt, wenn das Signal in der jeweiligen Periode abgeklungen ist. Hierdurch ist sichergestellt, daß in jeder Periode des Signals die auftretenden Störimpulse/Nachprellimpulse sicher bei der Ermittlung des Referenzsignals ausgeblendet werden.

Sofern sich aufgrund der Betriebsführung der Brennkraftmaschine zunächst Signale des Gebers einstellen, die eine sehr große Amplitude aufweisen und anschließend -zum Beispiel durch einen Schubbetrieb- nur noch sehr kleine Signale abgegeben werden, so läßt sich mittels einer Entladeschaltung nach der jeweiligen Triggerung zumindest eine Teilentladung des Kondensators durchführen. Diese Entladung erfolgt in einem sehr kurzen Zeitraum und dient dazu, daß sich die Kondensatorspannung (Referenzwert) schnell der neuen Situation anpassen kann.

Ferner kann ein zweiter Komparator vorgesehen sein, der zum Vergleich der Amplituden des Signals mit den Referenzwerten herangezogen wird. Dieser Komparator legt damit den 20%-Wert der vorhergehenden maximalen Amplitude im betrachteten Anteil der zugehörigen Periode des Signals fest.

Das Signal kann von dem bereits erwähnten Geber stammen, der dem Einspritzventil der Brennkraftmaschine zugeordnet ist. Das Triggersignal kennzeichnet den Spritzbeginn des Einspritzventils.

### Zeichnung

Die Erfindung wird im folgenden anhand der Figuren näher erläutert. Es zeigen:
- Figur 1: ein Schaltbild einer Triggerschaltung und
- Figur 2: ein Diagramm des Signals eines Gebers.

### Beschreibung des Ausführungsbeispiels

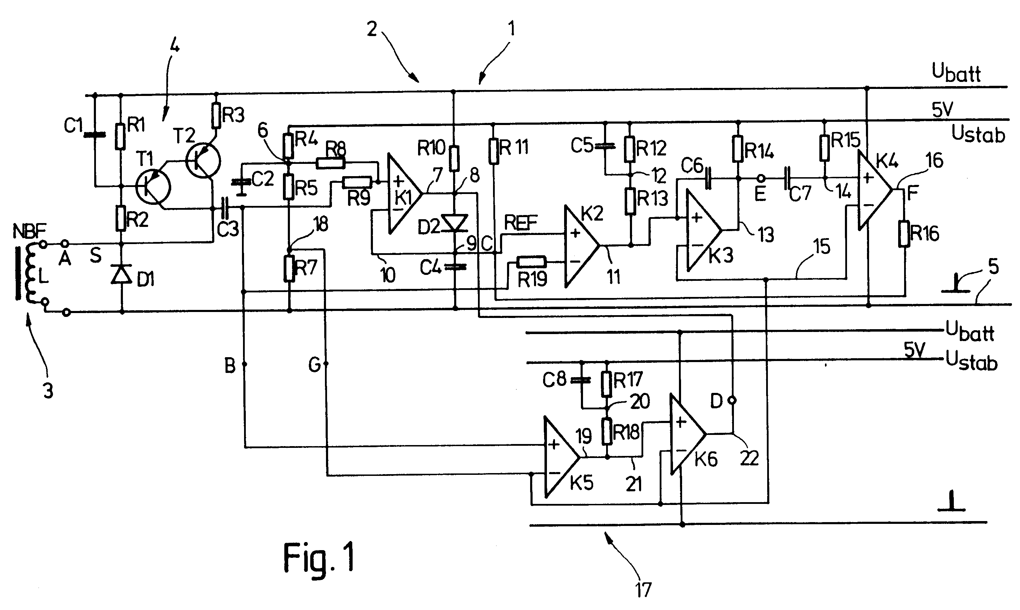

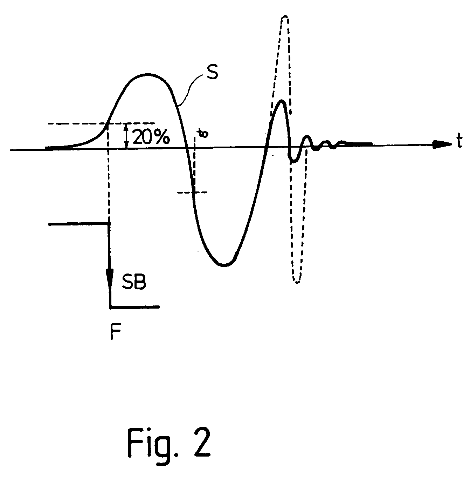

Die Figur 1 zeigt eine Schaltungsanordnung 1, die eine Triggerschaltung 2 aufweist. Die Triggerschaltung 2 dient zur Auswertung eines Signals S, das von einem Geber 3 geliefert wird. Der Geber 3 ist als induktiver Nadelbewegungsfühler NBF ausgebildet. Er wirkt mit einem nicht dargestellten Einspritzventil einer Brennkraftmaschine zusammen. Die Brennkraftmaschine ist als Dieselmotor ausgebildet. Sie weist eine Kraftstoffpumpe auf, die bei jedem Pumphub das Einspritzventil öffnet, wodurch der Nadelbewegungsfühler NBF anspricht und das Signal S (Figur 2) abgibt.

Im dargestellten Ausführungsbeispiel der Figur 1 wird eine Spule L des Nadelbewegungsfühlers NBF von einer geregelten Stromquelle 4 versorgt. Die Stromquelle 4 wird von den Transistoren T1 und T2 sowie der zugehörigen Beschaltung (Widerstände R1, R2 und R3, Kondensator C1) gebildet. Mit der Spule L wirkt ein Eisenkern zusammen, der bei der Betätigung des Einspritzventils bewegt wird und dadurch eine Induktionsänderung in der Spule L hervorruft, die zur Bildung des Signals S führt, das zwischen einer Klemme A und Masse 5 liegt. Parallel zur Spule L ist eine Diode D1 geschaltet.

Die Klemme A ist über einen Kondensator C3 und einen Widerstand R9 mit dem Pluseingang eines Komparators K1 verbunden. Ferner ist ein aus den Widerständen R4, R5 und R7 bestehender Spannungsteiler vorgesehen, wobei ein zwischen den Widerständen R4 und R5 liegender Verbindungspunkt 6 über einen Widerstand R8 zum Pluseingang des Komparators K1 führt. Der Verbindungspunkt 6 ist ferner über einen Kondensator C2 an Masse 5 geschaltet. Der erwähnte Spannungsteiler wird von einer stabilisierten Spannung U_{stab} versorgt. Die stabilisierte Spannung hat die Größe von 5 Volt.

Ferner ist eine Batteriespannung U_{batt} vorgesehen, die unter anderem die Stromquelle 4 mit Energie versorgt.

Der Ausgang 7 des Komparators K1 führt zu einem Verbindungspunkt 8, der über einen Widerstand R10 mit der Batteriespannung U_{batt} verbunden ist. Ferner liegt die Anode einer Diode D2 am Verbindungspunkt 8, deren Kathode zu einem Verbindungspunkt 9 führt. Zwischen dem Verbindungspunkt 9 und Masse 5 ist ein Kondensator C4 geschaltet. Ferner ist der Minuseingang des Komparators K1 über eine Leitung 10 an den Verbindungspunkt 9 angeschlossen. Eine Klemme C, die zum Verbindungspunkt 9 führt, ist über einen Widerstand R11 an die stabilisierte Spannung U_{stab} angeschlossen. Er steht ferner mit dem Pluseingang eines weiteren Komparators K2 in Verbindung. Der Minuseingang des Komparators K2 führt über einen Widerstand R19 an eine Klemme B, die zwischen dem Kondensator C3 und dem Widerstand R9 liegt.

Der Ausgang 11 des Komparators K2 ist an eine Reihenschaltung von Widerständen R12, R13 angeschlossen, die zur stabilisierten Spannung U_{stab} führen. Ein Verbindungspunkt 12 der zwischen den Widerständen R12 und R13 liegt, führt über eine Kapazität C5 zur stabilisierten Spannung U_{stab}.

Ferner steht der Ausgang 11 des Komparators K2 mit dem Pluseingang eines Komparators K3 in Verbindung. Dieser Komparator K3 weist einen Ausgang 13 auf, der über eine Kapazität C6 zum Pluseingang des Komparators K3 führt. Ferner ist der Ausgang 13 mit einer Klemme E verbunden, zwischen der und der stabilisierten Spannung U_{stab} ein Widerstand R14 liegt. Ferner ist ein RC-Glied vorgesehen, das von einem Widerstand R15 und einem Kondensator C7 gebildet ist. Der Kondensator C7 steht mit der Klemme E in Verbindung; der Widerstand R15 ist an die stabilisierte Spannung U_{stab} angeschlossen. Ein Verbindungspunkt 14, der zwischen dem Widerstand R15 und dem Kondensator C7 liegt, ist an den Pluseingang eines weiteren Komparators K4 angeschlossen. Der Minuseingang des Komparators K3 steht über eine Leitung 15 mit dem Minuseingang des Komparators K4 in Verbindung. Der Ausgang 16 des Komparators K4 ist über einen Widerstand R16 mit der Klemme C verbunden.

Schließlich ist eine Ausblendschaltung 17 vorgesehen, aie einen Komparator K5 aufweist. Dessen Minuseingang ist an eine Klemme G angeschlossen, die zu einem Verbindungspunkt 18 führt, der zwischen dem Widerstand R5 und dem Widerstand R7 des zuvor erwähnten Spannungsteilers liegt. Der Pluseingang des Komparators K5 führt zur Klemme B. Der Ausgang 19 des Komparators K5 führt zu einem Spannungsteiler, der von Widerständen R17 und R18 gebildet wird. Der Widerstand R17 liegt mit einem Anschluß an der stabilisierten Spannung U_{stab}. Ein Verbindungspunkt 20, der zwischen den Widerständen R17 und R18 liegt, ist über einen Kondensator C8 an die stabilisierte Spannung U_{stab} angeschlossen.

Ferner steht der Ausgang 19 über eine Leitung 21 mit dem Pluseingang eines letzten Komparators K6 in Verbindung, dessen Minuseingang zum Minuseingang des Komparators K5 führt. Der Ausgang 22 des Komparators K6 ist an eine Klemme D angeschlossen, die zum Verbindungspunkt 8 führt. Die Komparatoren K1, K2, K3, K4, K5 und K6 werden von der Batteriespannung U_{batt} versorgt (nur teilweise in Figur 1 wiedergegeben).

Die Schaltungsanordnung 1 funktioniert folgendermaßen:
Das Signal S wird über den Kondensator C3 und über den Widerstand R19 zum Minuseingang des Komparators K2 übertragen. Dieser Komparator K2 stellt einen Haupt-Auswertekomparator dar. Er vergleicht das Signal S mit einem an seinem Pluseingang liegenden Referenzwert REF, der an der Klemme C und somit am Kondensator C4 liegt. Überschreitet das Signal S am Minuseingang des Komparators K2 den Referenzwert REF, so schaltet auch der Komparator K3, wodurch am Punkt E eine negative Flanke F auftritt, die den Spritzbeginn SB des erwähnten Einspritzventils kennzeichnet.

Die Größe des Referenzwerts REF ist proportional zum Spitzenwert einer ersten Halbwelle der vorangegangenen Periode des Signals S. Dies ergibt sich aus folgenden Gründen: Die Klemme B hat -ohne Signal S- ein geringfügig niedrigeres Potential als die stabilisierte Spannung U_{stab}. Letztere beträgt 5 Volt; vorzugsweise kann das niedrige Potential des Punkts B 4,9 Volt betragen. Der Kondensator C4 (Anschluß C) ist über den sehr hochohmigen Widerstand R11 auf den Wert der stabilisierten Spannung U_{stab} = 5 Volt aufgeladen, so daß die Grundschwelle (Referenzwert REF) 5 Volt beträgt. Treten nur sehr kleine Amplituden bei dem Signal S auf, so bildet diese Grundschwelle von 5 Volt den Referenzwert REF am Komparator K2. Tritt an der Klemme E die negative Flanke auf, so wird dem Rechner des Steuergeräts der Spritzbeginn signalisiert.

Treten größere Amplituden des Signals S auf, zum Beispiel aufgrund einer größeren Drehzahl oder einer höheren Last der Brennkraftmaschine, so werden diese aufgrund der Widerstände R8 und R9 derart abgesenkt, daß sie nur noch 20% der ursprünglichen Amplitude betragen. Der Komparator K1 bildet zusammen mit der Diode D2 und dem Widerstand R10 eine schwellenwertlose Gleichrichterschaltung, die den Kondensator C4 auf diesen 20%-Wert auflädt. Da der Widerstand R11 sehr hochohmig ist, wird das Potential an C4 (Referenzwert REF) zwischen zwei Perioden des Signals S so gut wie nicht abgebaut. Mithin wird für die Folgeperiode des Signals S dieser Referenzwert REF als Schwelle von dem Komparator K2 herangezogen. Damit bestimmt die maximale Amplitude der vorhergehenden Periode des Signals S den Referenzwert REF in der Folgeperiode des Signals S.

Erfindungsgemäß ist vorgesehen, daß zur Aufladung des Kondensators C4, also für die Bereitstellung des Referenzwerts REF, nicht die gesamte Vorperiode des Signals S ausgewertet wird, da sonst unter Umständen von viel zu großen Amplitudenspitzen ausgegangen wird, die von Nachprellimpulsen stammen und daher zu einer Verfälschung bei der Ermittlung des Spritzbeginns führen würden. Um dies zu vermeiden, wird zur Ermittlung des Referenzwerts REF nur von einem Anteil der entsprechenden Periode des Signals S ausgegangen. Dieser Anteil wird derart ausgewählt, daß er die erwähnten Nachprellimpulse nicht enthält. Vorzugsweise wird nur die erste Halbwelle, insbesondere positive Halbwelle, jeder Periode des Signals S für die Bestimmung des Referenzwerts REF herangezogen. Die Ausblendung des mit Störungen, insbesondere Prellimpulsen, versehenen Bereichs der Periode wird von der Ausblendschaltung 17 vorgenommen.

Wie bereits vorstehend erwähnt, weist die Klemme B ein etwas niedrigeres Potential als die stabilisierte Spannung U_{stab} auf. Die Klemme B liegt zum Beispiel auf 4,9 Volt. Aufgrund des Spannungsteilers, der durch R4, R5 und R7 gebildet ist, liegt das Potential an der Klemme G tiefer als an der Klemme B. Es beträgt zum Beispiel 4,5 Volt. Die Potentiale der Klemmen B und G werden auf die Eingänge des Komparators K5 gegeben. Das Potential an der Klemme G wird dem Minuseingang zugeführt und bildet einen Bezugswert. Solange kein Signal S vom Nadelbewegungsfühler NBF abgegeben wird, befindet sich der Komparator K5 an seinem Ausgang 19 auf "High"-Potential. Wenn der Geber 3 die erste positive Halbwelle des Signals S (Figur 2) liefert und diese über die Kapazität C2 zum Pluseingang des Komparators K5 gelangt, so bleibt der Ausgang 19 auf seinem "High"-Potential. Erst dann, wenn das Potential am Pluseingang des Komparators K5 kleiner als das Potential am Minuseingang wird, schaltet der Komparator K5. Dies bedeutet, daß die erste negative Halbwelle -die sich an die erste positive Halbwelle des Signals S anschließt- dazu führt, daß der Komparator K5 schaltet; sein Ausgang 19 somit den "Low"-Zustand annimmt. Der Schaltzeitpunkt des Komparators K5 ist in Figur 2 mit t₀ bezeichnet. Das "Low"-Potential auf der Leitung 21 führt ebenfalls zum Schalten des Komparators K6, wodurch auch der Ausgang 22 des Komparators K6 den "Low"-Zustand annimmt. Hierdurch wird quasi Massepotential an den Verbindungspunkt 8 gelegt, wodurch die Diode D2 in ihren Sperrzustand gelangt. Dies wiederum bedeutet, daß über die Diode D2 der Kondensator C4 nicht weiter aufgeladen werden kann, das heißt, der durch die erste Halbwelle der zugehörigen Periode des Signals S am Kondensator C4 hervorgerufene Referenzwert, der 20% der Spitzenamplitude dieser ersten Halbwelle beträgt, bleibt gespeichert. Verfälschungen durch nachfolgende, noch größere Amplituden entfallen, da diese Amplituden (Nachprellimpulse) durch Sperrung der Diode D2 nicht an den Kondensator C4 gelegt werden.

Zusammen mit den Kondensator C8 und dem Widerstand R17 bilden die Komparatoren K5 und K6 eine monostabile Funktion aus, die derart gewählt ist, daß die Rückschaltung in den Ausgangszustand der Komparatoren K5 und K6 erst erfolgt, wenn das Signal S in der jeweilig betrachteten Periode wieder abgeklungen ist, das heißt also, wenn die Nachprellimpulse verschwunden sind. Der Vorzeichenwechsel des Signals S zum Zeitpunkt t₀ hat ferner die physikalische Bedeutung, daß das zugehörige Einspritzventil nunmehr seinen geöffneten Zustand einnimmt. Diese Information kann von der Klemme D abgenommen und vom Rechner des Steuergeräts verarbeitet werden. Hierbei ist zu bedenken, daß die Zeitlinie in der Figur 2 nicht unbedingt mit einer Null-Volt-Potential-Linie übereinstimmen muß, vielmehr kann sie auch eine Mittelwertlinie darstellen, die ein positives Potential aufweist, so daß nur fiktiv von "positiver" und "negativer" Halbwelle geredet werden kann.

Da das Potential am Kondensator C4, also der Referenzwert REF, über den hochohmigen Widerstand R11 nur sehr langsam abgebaut wird, würden einige Signale S gar nicht erkannt werden können, wenn zunächst sehr große Signale S und danach, zum Beispiel aufgrund des Schubbetriebs der Brennkraftmaschine, plötzlich sehr kleine Signale S auftreten. Um dieses Problem zu vermeiden, wird der Komparator K4 geschaltet. Jeder Spritzimpuls (Klemme E) erzeugt aufgrund der Widerstands-Kondensator-Kombination R15, C7 einen sehr kurzen Differenzierimpuls, der am Ausgang 16 des Komparators K4 eine kurze negative Spitze erzeugt (Klemme F). Dies führt dazu, daß der Kondensator C4 über den Widerstand R16 nach erkanntem Spritzbeginn SB für eine sehr kurze Zeit teilweise entladen wird. Hierdurch wird eine Dynamik erzeugt, so daß auch beim Übergang von sehr großen auf sehr kleine Signale S stets der aktuelle 20%-Amplitudenwert am Kondensator C4 gespeichert werden kann. Die zuvor beschriebene Entladung des Kondensators C4 wird nicht vollständig vorgenommen, sondern führt lediglich zu einer Teilentladung. Sie muß auch schon kurz nach der SB-Erkennung der entsprechenden Periode wieder abgeschlossen sein, da sonst diese Funktion mit der Aufladefunktion des Widerstands R10 kollidieren würde.

## Patentansprüche

1. Triggerschaltung, die die Amplituden des Signalverlaufs eines periodischen Signals mit vom vorausgehenden Signalverlauf dieses Signals abhängigen Referenzwerten vergleicht und beim Erreichen des jeweiligen Referenzwerts ein Triggersignal abgibt, sowie mit einem Speicher für den jeweiligen Referenzwert, dadurch gekennzeichnet, daß Mittel vorhanden sind, die nur die erste Halbwelle jeder Periode des Signalverlaufs für die Bestimmung des Referenzwertes heranziehen.

2. Triggerschaltung nach Anspruch 1, dadurch gekennzeichnet daß der Speicher als Kondensator (C4) ausgebildet ist und daß der Referenzwert proportional zum Spitzenwert der ersten Halbwelle der Periode des Signals (S) ist.

3. Triggerschaltung nach Anspruch 2, gekennzeichnet durch einen ersten Komparator (K5), der bei den ersten innerhalb einer Periode erfolgenden Vorzeichenwechsels des Signals (S) ein Ausgangssignal abgibt, das eine durch das Signal (S) erfolgende Aufladung des Kondensators (C4) stoppt.

4. Triggerschaltung nach Anspruch 3, dadurch gekennzeichnet daß zum Kondensator (C4) eine Diode (D2) in Reihe liegt, die von dem ersten Komparator (K5) (über K6) in ihren Sperrzustand steuerbar ist.

5. Triggerschaltung nach einem Ansprüche 3 oder 4, dadurch gekennzeichnet, daß der erste Komparator (K5) eine monostabile Funktion aufweist, wobei die Rückschaltung in seinen Ausgangszustand erst erfolgt, wenn das Signal (S) der jeweiligen Periode abgeklungen ist.

6. Triggerschaltung nach einem der Ansprüche 3 bis 5, gekennzeichnet durch eine Entladeschaltung (K4, R 16), die nach der Triggerung zumindest eine Teilentladung des Kondensators (C4) durchführt.

7. Triggerschaltung nach einem der vorhergehenden Ansprüche, gekennzeichnet durch einen zweiten Komparator (K2) zum Vergleich der Amplitude des Signals (S) mit den Referenzwerten.

8. Triggerschaltung nach einem der vorhergehenden Ansprüche, dadurch gekennzeichnet, daß das Signal von einem Geber (3) stammt, der einem Einspritzventil einer Brennkraftmaschine zugeordnet ist.

9. Triggerschaltung nach einem der vorhergehenden Ansprüche, dadurch gekennzeichnet, daß das Triggersignal den Spritzbeginn des Einspritzsignals kennzeichnet.

10. Triggerschaltung nach einem der Ansprüche 3 bis 9, dadurch gekennzeichnet, daß das Schalten des ersten Komparators (K5) als Eintrittszeitpunkt des Einspritzventils-Offenstellung erfaßt/verwendet wird.

11. Triggerschaltung nach einem der Ansprüche 7 bis 10, dadurch gekennzeichnet, daß dem zweiten Komparator (K2) eine Grundschwelle zugeordnet wird mittels eines hochohmigen Widerstandes (R11) von einer Stromversorgung (Ustab) auf den Kondensator (C4).

## Claims

1. A trigger circuit which compares the amplitudes of the signal variation of a periodic signal with reference values dependent on the preceding signal variation of this signal and outputs a trigger signal when the respective reference value is reached, and with a memory for the respective reference value, characterized in that means are provided which only use the first half-wave of each period of the signal variation for determining the reference value.

2. Trigger circuit according to Claim 1, characterized in that the memory is constructed as capacitor (C4) and in that the reference value is proportional to the peak value of the first half-wave of the period of the signal (S).

3. Trigger circuit according to Claim 2, characterized by a first comparator (K5) which, at the first change of the sign of the signal (S) occurring within one period, outputs an output signal which stops a charging-up of the capacitor (C4) occurring due to the signal (S).

4. Trigger circuit according to Claim 3, characterized in that a diode (D2), which can be driven into its blocked state by the first comparator (K5) (via K6), is connected in series with the capacitor (C4).

5. Trigger circuit according to one of Claims 3 or 4, characterized in that the first comparator (K5) exhibits a monostable function, the resetting to its initial state only taking place when the signal (S) of the respective period has decayed.

6. Trigger circuit according to one of Claims 3 to 5, characterized by a discharge circuit (K4, R 16) which at least partially discharges the capacitor (C4) after the triggering.

7. Trigger circuit according to one of the preceding claims, characterized by a second comparator (K2) for comparing the amplitude of the signal (S) with the reference values.

8. Trigger circuit according to one of the preceding claims, characterized in that the signal originates from a transmitter (3) which is allocated to an injection valve of an internal combustion engine.

9. Trigger circuit according to one of the preceding claims, characterized in that the trigger signal identifies the beginning of injection of the injection signal.

10. Trigger circuit according to one of Claims 3 to 9, characterized in that the switching of the first comparator (K5) is detected/used as starting time for the open position of the injection valve.

11. Trigger circuit according to one of Claims 7 to 10, characterized in that a basic threshold is allocated to the second comparator (K2) by means of a high-resistance resistor (R11) from a power supply (Ustab) to the capacitor (C4).

## Revendications

1. Circuit de déclenchement qui compare les amplitudes de l'évolution d'un signal périodique à des valeurs de référence dépendant de l'évolution précédente de ce signal, et qui lorsque la valeur de référence considérée est atteinte, délivre un signal de déclenchement, tandis qu'une mémoire est prévue pour la valeur de référence considérée, circuit de déclenchement caractérisé en ce qu'il est prévu des moyens qui n'utilisent que la première demi-onde de chaque période de l'évolution du signal pour la détermination de la valeur de référence.

2. Circuit de déclenchement selon la revendication 1, caractérisé en ce que la mémoire revêt la forme d'un condensateur (C4) et en ce que la valeur de référence est proportionnelle à la valeur de pointe de la première demi-onde de la période du signal (S).

3. Circuit de déclenchement selon la revendication 2, caractérisé en ce qu'il comporte un premier comparateur (K5) qui, lors du premier changement de signe du signal (S) s'effectuant à l'intérieur d'une période, délivre un signal de sortie qui stoppe une charge du condensateur (C4) s'effectuant par l'intermédiaire du signal (S)

4. Circuit de déclenchement selon la revendication 3, caractérisé en ce qu'avec le condensateur (C4) est placée en série une diode (D2) qui est susceptible d'être commandée dans son état de blocage à partir du premier comparateur (K5) (par l'intermédiaire de K6).

5. Circuit de déclenchement selon une des revendications 3 ou 4, caractérisé en ce que le premier comparateur (K5) a une fonction monostable, si bien que la commutation en retour dans son état de départ, ne s'effectue que lorsque le signal (S) de la période considérée, s'est évanoui.

6. Circuit de déclenchement selon l'une des revendications 3 à 5, caractérisé par un circuit de décharge (K4, R16) qui après le déclenchement, effectue au moins une décharge partielle du condensateur (C4).

7. Circuit de déclenchement selon une des précédentes revendications, caractérisé en ce qu'il comporte un second comparateur (K2) pour comparer l'amplitude du signal (S) avec les valeurs de référence.

8. Circuit de déclenchement selon une des précédentes revendications, caractérisé en ce que le signal émane d'un émetteur (3) qui est associé à une soupape d'injection d'un moteur à combustion interne.

9. Circuit de déclenchement selon une des précédentes revendications, caractérisé en ce que le signal de déclenchement caractérise le début du signal d'injection.

10. Circuit de déclenchement selon une des revendications 3 à 9, caractérisé en ce que la commutation du premier comparateur (K5) est détectée et utilisée en tant qu'instant d'arrivée de la position d'ouverture de la soupape d'injection.

11. Circuit de déclenchement selon une des revendications 7 à 10, caractérisé en ce qu'au second comparateur (K2) est associé un seuil de base au moyen d'une résistance (R11) de valeur ohmique élevée, d'une alimentation en courant (U_{stab}) sur le condensateur (C4).
